# NEUE EUROPÄISCHE PATENTSCHRIFT

(11) **EP 2 181 480 B2**
(45) Veröffentlichungstag und Bekanntmachung des Hinweises auf die Entscheidung über den Einspruch: **31.03.2021**
(45) Hinweis auf die Patenterteilung: 07.10.2015
(21) Anmeldenummer: 08774476.9
(22) Anmeldetag: 27.06.2008
(51) Int. Cl.: H01M 10/48, G01R 31/36

(54) **AKKU- BZW. BATTERIEPACK**
BATTERY OR RECHARGEABLE-BATTERY PACK
ENSEMBLE D'ACCUMULATEURS ET/OU DE BATTERIES

(30) Priorität: 16.08.2007 DE 102007038532
(43) Veröffentlichungstag der Anmeldung: 05.05.2010
(73) Patentinhaber: Robert Bosch GmbH, 70442 Stuttgart (DE)
(72) Erfinder: OSSWALD, Alexander, 70599 Stuttgart (DE); HEINRICH, Thomas, 70771 Leinfelden (DE)
(86) Internationale Anmeldenummer: PCT/EP2008/058315
(87) Internationale Veröffentlichungsnummer: WO 2009/021771

(56) Entgegenhaltungen:
- EP-A- 1 067 393
- WO-A-98/32181
- WO-A-99/05766
- DE-A1- 19 822 571
- US-A- 5 712 568
- US-A- 5 808 469
- US-A1- 2004 199 343
- "Kopplung (Elektronik)", Wikipedia, 11 April 2015, Seiten 1-2
- "Kopplung (Elektronik)", Wikipedia, 28 September 2007, Seite 1
- "Kopplung (Elektronik)", Wikipedia, 1 June 2006, Seite 1

## Beschreibung

### Technisches Gebiet

Die vorliegende Erfindung betrifft ein Akku- bzw. Batteriepack mit eingebauten Überwachungsschaltungen zum Überwachen des Betriebs der einzelnen spannungsliefernden Zellen.

### Stand der Technik

Derartige Akku- bzw. Batteriepacks werden beispielsweise in Laptops oder Power Tools verwendet, wobei z. B. bei Li-Ionen-Akkus die Spannung jeder einzelnen Zelle überwacht wird und eine Fehlfunktion der Zelle an ein Ladegerät oder an einen Verbraucher ausgegeben wird, wenn eine Überwachungsschaltung feststellt, dass die Spannung einer Zelle unter einen vorbestimmten Grenzwert gefallen ist.

Bei diesen herkömmlichen Systemen kann jedoch jeweils nur eine begrenzte Anzahl von einzelnen Zellen überwacht werden, da bei der üblichen parallelen Verbindung von jeder Überwachungsschaltung mit einer Signalauswertungsschaltung schon bei mehr als 10 - 20 Zellen die Gesamtspannung zu hoch wird, um noch eine Erfassung einzelner Zelleninformations-Signale zu ermöglichen. Insbesondere für Anwendungen, bei denen besonders leistungsfähige Akku- bzw. Batteriepacks benötigt werden, wäre es aber vorteilhaft, eine größere Anzahl einzelner Zellen, in der Größenordnung von mehreren Hunderten oder sogar bis zu Tausend, zu einem Akku- bzw. Batteriepack zusammenfassen zu können, und dann auch in diesem Akku- bzw. Batteriepack weiterhin die Funktion jeder einzelnen Zelle zuverlässig überwachen zu können.

Demgegenüber ist es Aufgabe der vorliegenden Erfindung, ein Akku- bzw. Batteriepack bereitzustellen, wobei eine beliebige Anzahl einzelner Zellen einfach überwacht werden kann.

Diese Aufgabe wird durch den Akku- bzw. Batteriepack gemäß Anspruch 1 gelöst.

Weitere vorteilhafte Ausgestaltungen der Erfindung sind in den abhängigen Ansprüchen angegeben.

### Offenbarung der Erfindung

Zur Lösung der oben genannten Aufgabe stellt die vorliegende Erfindung eine Vorrichtung, insbesondere ein Akku- bzw. Batteriepack bereit, umfassend mehrere einzelne miteinander verbundene Spannung liefernde Zellen, wobei jeder Zelle eine Überwachungsschaltung zugeordnet ist, um die Funktion der Zelle zu überwachen und um abhängig davon eine Zelleninformation bereitzustellen, und wobei jede Überwachungsschaltung mit einer Kopplungsanordnung gekoppelt ist, die abhängig von den Zelleninformationen das Bereitstellen eines galvanisch getrennten Zustandssignals derart bewirkt, dass die Überwachungsschaltung über die Kopplungsanordnung von einer das Zustandssignal bereitstellenden Signalauswertungsschaltung galvanisch getrennt ist. Hierdurch kann durch das Bereitstellen des galvanisch getrennten Zustandssignals und somit über die galvanische Trennung der Zellen und ihrer Überwachungsschaltungen von einer Signalauswertungsschaltung sichergestellt werden, dass auch bei einer großen Anzahl von einzelnen

Zellen keine übermäßig hohe Spannung an der Signalauswertungsschaltung anliegt. Die Signalauswertungsschaltung kann hierbei außerhalb des Akku- bzw. Batteriepacks vorgesehen sein, welches dann lediglich die Spannung liefernden Zellen, ihre zugeordneten Überwachungsschaltungen und die Kopplungsanordnung umfasst. Eine externe, beispielsweise in einem Ladegerät vorgesehene Signalauswertungsschaltung kann dann zur Auswertung des Zustandssignals mit den im Akku- bzw. Batteriepack vorgesehenen Kopplungsanordnungen verbunden werden.

Somit kann eine prinzipiell beliebig erweiterbare Anzahl von einzelnen Zellen überwacht werden, so dass auch Akku- bzw. Batteriepacks mit einer sehr großen Anzahl von Zellen einfach realisiert werden können. Weiterhin ermöglicht eine derartige galvanische Trennung auch einen einfacheren Austausch einzelner Zellen zusammen mit ihren zugeordneten Überwachungsschaltungen.

Hierbei kann vorgesehen sein, dass die Kopplungsanordnung ein erstes Kopplungselement zum Kommunizieren mit einem außerhalb des Akku- bzw. Batteriepacks angeordneten zweiten Kopplungselement umfasst. Hierbei ist somit nur ein Kopplungselement im Akku- bzw. Batteriepack enthalten, so dass beim Einbau dieses Akku- bzw. Batteriepacks keine Leitungsverbindung zu einer Signalauswertungsschaltung werden muss, sondern lediglich die galvanisch getrennte Signalverbindung zwischen dem im Akku- bzw. Batteriepack vorgesehenen ersten Kopplungselement und einem beispielsweise in einem Ladegerät vorgesehenen zweiten Kopplungselement hergestellt werden muss.

Bei einem derartigen Akku- bzw. Batteriepack kann eine Signalauswertungsschaltung vorgesehen sein, welche jeweils mit den Kopplungsanordnungen gekoppelt ist, und welche abhängig von den Zelleninformationen ein Signal an ein Ladegerät oder einen Verbraucher bereitstellt. Mit der im Akku- bzw. Batteriepack vorgesehenen Signalauswertungsschaltung sind somit die komplette Überwachung der Zellen inkl. der Bereitstellung eines Fehlfunktions-Signals bei der Fehlfunktion einer einzelnen Zelle bereits im Akku- bzw. Batteriepack enthalten, so dass ein derartiges Akku- bzw. Batteriepack besonders einfach in ein Gerät integriert werden kann.

Die Kopplungsanordnung umfasst eine Einrichtung zum Herstellen einer Funkverbindung.

Es ist nicht zwingend notwendig, dass jeder Zelle eine eigene Überwachungsschaltung zugeordnet ist, sondern einer Überwachungsschaltung können jeweils mehrere Spannung liefernde Zellen zugeordnet sein. Durch eine derartige kaskadierte Anordnung aus Akkuzellen und Überwachungsschaltungen können noch einfacher große Mengen einzelner Spannung liefernder Zellen überwacht werden. Weiterhin können, verglichen mit einem Bereitstellen von einer eigenen Überwachungsschaltung für jede Zelle, Überwachungsschaltungen und Kopplungsanordnungen eingespart werden.

Jede Überwachungsschaltung kann hierbei jeweils die Spannung und/oder die Temperatur und/oder den Innendruck und/oder den Innenwiderstand und/oder die Feuchtigkeit der ihr zugeordneten Zelle/n überwachen. Durch die Überwachung derartiger zellentypischer Parameter können sowohl der Ladungszustand als auch mögliche Fehlfunktionen (z. B. Elektrolyt-Austritt) jeder einzelnen Spannung liefernden Zelle schnell erfasst werden.

Falls die Signalauswertungsschaltung im Akku- bzw. Batteriepack vorgesehen ist, stellt sich als weiterer, separater Aspekt der Erfindung das Problem, wie ein von den Zelleninformationen abhängiges Signal, das über die Kopplungsanordnungen an die Signalauswertungsschaltung übermittelt worden ist, mit möglichst geringen Aufwand einem Ladegerät oder einem Verbraucherbereitgestellt werden kann, um beispielsweise einen Ladevorgang zu beenden oder um bei geringem Ladungszustand den Strombedarf eines Verbrauchers zu begrenzen. Die einfachste mögliche Verbindung ist hier das Vorsehen eines Kontakts an der Signalauswertungsschaltung, über den direkt an das Ladegerät oder den Verbraucher ein Spannungspegel gegenüber dem Minus- oder Pluspol des Akku- bzw. Batteriepacks abgegeben wird.

Dieser zusätzliche Kontakt ist jedoch unnötig, wenn beispielsweise im Akkuader Batteriepack bereits ein Temperaturfühler vorgesehen ist, der seinerseits bereits dem Ladegerät oder dem Verbraucher ein von der Temperatur des Akku- bzw. Batteriepacks abhängiges Signal bereitstellt. Die Signalauswertungsschaltung kann dann ein von den Zelleninformationen abhängiges Signal über diesen im Akku- oder Batteriepack vorhandenen Temperaturfühler an ein Ladegerät oder einen Verbraucher übermitteln, indem sie eine elektrische Größe des Temperaturfühlers beeinflusst. Dies kann bei einem NTC-Widerstand als Temperaturfühler beispielsweise dadurch erfolgen, dass dem NTC-Widerstand ein weiterer Widerstand parallel geschaltet wird. Dadurch wird ein Temperaturfühlersignal erzeugt, das eine hohe Temperatur anzeigt, wodurch eine Beendigung des Lade- oder Entladevorgangs bewirkt wird. Alternativ kann dem Temperaturfühler auch ein von der Zelleninformation abhängiges Signal überlagert werden oder der Temperaturfühler kann kurzgeschlossen oder unterbrochen werden, so dass wiederum ein von der Zelleninformation abhängiges Signal an das Ladegerät oder den Verbraucher übermittelt werden kann, ohne dass außer dem bereits vorhandenen Temperaturfühler ein weiterer Anschluss zur Signalübermittlung von dem Akku- bzw. Batteriepack an das Ladegerät oder den Verbraucher bereitgestellt werden muss.

Die Signalauswertungsschaltung kann ein von der Zelleninformation abhängiges Signal auch über eine optische oder eine Funkschnittstelle oder über eine induktive oder eine kapazitive Kopplungseinheit an ein Ladegerät oder einen Verbraucher bereitstellen. Auch hier entfällt die Notwendigkeit für einen direkten Anschluss der Signalauswertungsschaltung an das Ladegerät oder den Verbraucher.

Weiterhin kann die Signalauswertungsschaltung in Abhängigkeit von der Zelleninformation über einen im Akku- bzw. Batteriepack vorgesehenen Schalter den Stromfluss in oder aus dem Akku unterbrechen und somit ohne die Notwendigkeit einer Signalübermittlung an das Ladegerät oder den Verbraucher selbsttätig den Lade- oder Entladevorgang beenden.

### Kurzbeschreibung der Zeichnungen

Im Folgenden werden nicht erfindungsgemäße Ausführungsformen beispielhaft an- hand der beigefügten Zeichnungen beschrieben.
- Fig. 1: ist eine schematische Darstellung des Schaltungsaufbaus einer ersten Ausführungsform des nicht erfindungsgemäßen Akku- bzw. Batterie- packs, und
- Fig. 2: ist eine schematische Darstellung des Schaltungsaufbaus einer zweiten Ausführungsform des nicht erfindungsgemäßen Akku- bzw. Batterie- packs.

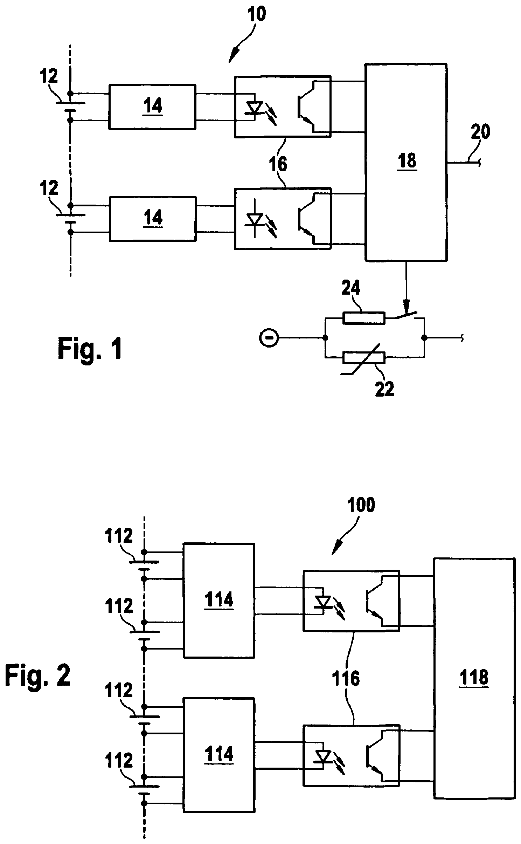

Wie aus Fig. 1 ersichtlich, umfasst ein Akku- bzw. Batteriepack 10 gemäß der ersten Ausführungsform der vorliegenden Erfindung eine Mehrzahl von einzelnen Spannung liefernden Zellen 12 (wieder aufladbar oder nicht wieder aufladbar, wie z.B. Akkuzellen oder Batteriezellen), welche jeweils mit einer Überwachungsschaltung 14 verbunden sind. Die Überwachungsschaltung 14 überwacht hierbei Betriebsparameter der ihr zugeordneten Zelle 12, wie beispielsweise die Zellenspannung (Über- oder Unterspannung), die Temperatur, den Innendruck, den Innenwiderstand oder die Feuchtigkeit der Zelle (um den Austritt von Elektrolyt erfassen zu können) und stellt eine entsprechende Zelleninformation bereit. Derartige Überwachungsschaltungen 14 sind grundsätzlich bereits bekannt und werden auch bei herkömmlichen Akkupacks zur Überwachung einzelner Akkuzellen verwendet.

Weiterhin ist eine Signalauswertungsschaltung 18 vorgesehen, die mit jeder Überwachungsschaltung 14 galvanisch getrennt (potentialfrei) über einen Optokoppler 16 verbunden ist. Hierbei kann die Signalauswertungsschaltung 18 entweder als Teil des Akku- bzw. Batteriepacks 10 vorgesehen sein, oder kann als separates Bauteil vorliegen, das an das Akku- bzw. Batteriepack 10 angeschlossen werden kann und z. B. in ein Ladegerät, mit dem der Akku- bzw. Batteriepack 10 geladen werden kann, oder einen Verbraucher, der durch den Akku- bzw. Batteriepack 10 betreibbar ist, integriert sein kann.

Der Optokoppler 16 ist hierbei eine Kopplungsanordnung 16, die in einem einzigen Bauteil ausgeführt ist. Anstelle des Optokopplers 16 kann auch eine Kopplungsanordnung vorgesehen sein, welche nur ein erstes Kopplungselement umfasst, wie beispielsweise eine Leuchtdiode, welche mit einem außerhalb des Akku- bzw. Batteriepacks vorgesehenen zweiten Kopplungselement, wie beispielsweise einer Photozelle, kommuniziert. In diesem Fall kann das zweite Kopplungselement mit der von dem extern zu dem Akku- bzw. Batteriepack 10 vorgesehenen Signalauswerteschaltung verbunden sein.

Weiterhin kann die Kopplungsanordnung eine induktive oder kapa- zitive Kopplung umfassen. Erfindungsgemäß umfasst die Kopplungsanordnung eine Funkverbindung (z.B. ein lokales Funknetzwerk innerhalb des Akkupacks). Bei derartigen Kopplungsanordnungen kann dann jeweils lediglich das erste Kopplungselement als Teil des Akku- bzw. Batteriepacks vorgesehen sein, wobei das zweite Kopplungselement mit der Signalauswertungsschaltung 18 gekoppelt ist, die dann ebenfalls als vom Akku- bzw. Batteriepack 10 getrenntes Bauteil vorgesehen ist.

Durch die galvanische Trennung zwischen den Überwachungsschaltungen 14 und der Signalauswertungsschaltung 18 treten beim Zusammenfassen einer großen Anzahl von einzelnen Zellen 12 zu einem Akku- bzw. Batteriepack 10 an der Signalauswertungsschaltung 18 keine hohen Spannungen auf, so dass prinzipiell eine unbegrenzte Anzahl von Zellen 12 vorgesehen sein kann. Weiterhin ist es einfach möglich, einen erfindungsgemäßen Akku- bzw. Batteriepack 10 um weitere einzelne Zellen 12 und Überwachungsschaltungen 14 zu erweitern, ohne dass hierfür aufwändige Maßnahmen an der Signalauswertungsschaltung 18 durchgeführt werden müssten. Auch der Austausch einzelner Zellen 12 (mit oder ohne ihren zugeordneten Überwachungsschaltungen 14) ist problemlos möglich, so dass beispielsweise kostengünstigere Zellen 12 mit höheren Toleranzen als bisher üblich verwendet werden können.

Die Signalauswertungsschaltung 18 kann dann direkt über einen Anschluss 20 des Akku- bzw. Batteriepacks 10 für ein Ladegerät oder für einen Verbraucher ein Signal bereitstellen, das den Ladezustand und/oder Feh-Ifunktionen einzelner Akkuzellen angibt. Hierzu kann als Signal beispielsweiseein Spannungspegeloder ein Bus-Kommunikationssignal verwendet werden.

Weiterhin kann über einen bereits zur Signalisierung einer erhöhten Temperatur in dem Akku- bzw. Batteriepack 10 vorgesehenen Temperaturfühler 22, wie beispielsweise einen Temperaturwiderstand, insbesondere einen NTC-Widerstand 22, eine elektrische Größe, wie z.B. ein elektrischer Widerstand oder eine Temperaturspannung oder ein Signal von der Signalauswertungsschaltung 18 zur Beendigung des Lade- oder Entladevorgangs an das Ladegerät und/oder den Verbraucher ausgegeben werden.

Hierbei ist beispielsweise denkbar, dass zu dem NTC-Widerstand 22 ein weiterer Widerstand 24 parallel geschaltet ist, der durch die Signalauswertungsschaltung 18 zuschaltbar ist. Durch Zuschalten des Widerstands 24 wird der Gesamtwiderstand der Anordnung reduziert und somit kann die Signalauswertungsschaltung 18 dem Ladegerät oder dem Verbraucher durch die entsprechende Widerstandsänderung eine zu hohe Temperatur signalisieren, obwohl diese nicht vorliegt, und dadurch z.B. eine Beendigung des Lade- oder Entladevorgangs seitens des angeschlossenen Ladegeräts bzw. des Verbrauchers bewirken. Alternativ wäre es ebenfalls denkbar, einem derartigen Temperaturfühler ein analoges oder digitales Signal zu überlagern, welches vom Ladegerät oder vom Verbraucher ausgewertet wird, oder einen derartigen Temperaturfühler oder ein sonstiges, im Akku- bzw. Batteriepack vorgesehenes Element (beispielsweise einen Kodierwiderstand) kurz zu schließen oder zu unterbrechen, um eine Beendigung des Lade- oder Entladevorgangs zu bewirken.

Bei der Ausführungsform, bei der die Signalauswerteschaltung in dem Akku- bzw. Batteriepack 10 integriert ist, kann die Signalübermittlung von der Signalauswertungsschaltung 18 zum Ladegerät oder Verbraucher weiterhin auch über eine optische Schnittstelle, eine Funkverbindung oder über eine induktive oder kapazitive Kopplung erfolgen, oder die Signalauswertungsschaltung 18 kann einen im Akku- bzw. Batteriepack 10 eingebauten Leistungsschalter derart steuern, dass abhängig von den Signalen der Überwachungsschaltungen 14 der Stromfluss in oder aus dem Akkupack 10 unterbrochen werden kann.

Fig. 2 zeigt einen Akkupack 100 gemäß einer abgewandelten zweiten Ausführungsform. Dieser unterscheidet sich vom Akkupack 10 gemäß der ersten Ausführungsform nur hinsichtlich des Aufbaus der Überwachungsschaltungen 114, die, im Gegensatz zu den Überwachungsschaltungen 14 der ersten Ausführungsform derart ausgestaltet sind, dass eine Überwachungsschaltung 114 jeweils die Betriebsparameter mehrerer einzelner Akkuzellen 112 überwachen und entsprechende Zelleninformationen über nicht erfindungsgemäße Op- tokoppler 116 der Signalauswertungsschaltung 118 be- reitstellen kann.

Durch diesen kaskadierten Aufbau ist es noch einfacher, große Anzahlen einzelner Akkuzellen 112 in einem Akkupack 100 zu überwachen, da lediglich vorgefertigte Module, jeweils umfassend mehrere Akkuzellen 112 und eine diesen zugeordnete Überwachungsschaltung 114, mit einer Signalauswertungsschaltung 118 und Optokopplern 116 (oder anderen Kopplungsanordnungen, wie in Zusammenhang mit der ersten Ausführungsform beschrieben) kombiniert werden müssen. Außerdem können hierbei Überwachungsschaltungen 114 und Kopplungsanordnungen 116 eingespart werden.

Bezüglich der Signalübermittlung von der Signalauswertungsschaltung 118 an ein Ladegerät oder an einen Verbraucher sind hier, wie bei der ersten Ausführungsform, wieder sowohl ein direkter Anschluss 120 als auch eine Signalübermittlung über einen bereits im Akku- bzw. Batteriepack 100 vorgesehenen Temperaturfühler (nicht gezeigt) oder eine galvanisch getrennte Kopplung denkbar.

## Patentansprüche

1. Akku- bzw. Batteriepack (10; 100), umfassend mehrere einzelne, miteinander verbundene, Spannung liefernde Zellen (12; 112), wobei jeder Zelle (12; 112) eine Überwachungsschaltung (14; 114) zugeordnet ist, um eine Funktion der Zelle (12; 112) zu überwachen und um abhängig davon eine Zelleninformation bereitzustellen, und wobei jede Überwachungsschaltung (14; 114) mit einer Kopplungsanordnung (16; 116) gekoppelt ist, die abhängig von den Zelleninformationen das Bereitstellen eines galvanisch getrennten Zustandssignals derart bewirkt, dass die Überwachungsschaltung (14; 114) über die Kopplungsanordnung (16; 116) von einer das Zustandssignal bereitstellenden Signalauswertungsschaltung (18; 118) galvanisch getrennt ist, **dadurch gekennzeichnet, dass** die Kopplungsanordnung (16; 116) eine Einrichtung zum Herstellen einer Funkverbindung umfasst.

2. Akku- bzw. Batteriepack (10; 100) nach Anspruch 1, **dadurch gekennzeichnet, dass** die Kopplungsanordnung (16; 116) ein erstes Kopplungselement zum Kommunizieren mit einem außerhalb des Akku- bzw. Batteriepacks (10; 100) angeordneten zweiten Kopplungselement umfasst.

3. Akku- bzw. Batteriepack (10; 100) nach Anspruch 1, **dadurch gekennzeichnet, dass** die Signalauswertungsschaltung (18; 118) ein von den Zelleninformationen abhängiges Signal über einen im Akku- oder Batteriepack (10; 100) vorhandenen Temperaturfühler (22) an das Ladegerät oder den Verbraucher bereitstellt, indem die Signalauswertungsschaltung (18; 118) eine elektrische Größe des Temperaturfühlers (22) beeinflusst.

4. Akku- bzw. Batteriepack (10; 100) nach Anspruch 1, **dadurch gekennzeichnet, dass** die Signalauswertungsschaltung (18; 118) ein von den Zelleninformationen abhängiges Signal über eine optische oder eine Funkschnittstelle oder über eine induktive oder eine kapazitive Kopplungseinheit an das Ladegerät oder den Verbraucher bereitstellt.

5. Akku- bzw. Batteriepack (10; 100) nach Anspruch 1, **dadurch gekennzeichnet, dass** die Signalauswertungsschaltung (18; 118) ausgebildet ist, um in Abhängigkeit von den Zelleninformationen über einen im Akku- bzw. Batteriepack (10; 100) vorgesehenen Schalter den Stromfluss in oder aus dem Akku- bzw. Batteriepack zu unterbrechen.

6. Akku- bzw. Batteriepack (100) nach einem der Ansprüche 1 bis 5, **dadurch gekennzeichnet, dass** einer der Überwachungsschaltungen (114) jeweils mehrere Spannung liefernde Zellen zugeordnet (112) sind.

## Claims

1. Rechargeable battery pack or battery pack (10; 100), comprising a plurality of individual cells (12; 112) which are mutually connected and supply a voltage, wherein each cell (12; 112) has a monitoring circuit (14; 114) assigned thereto in order to monitor a function of the cell (12; 112) and in order to provide an item of cell information on the basis thereof, and wherein each monitoring circuit (14; 114) is coupled to a coupling arrangement (16; 116) which provides an electrically isolated state signal on the basis of the items of cell information such that the monitoring circuit (14; 114) is electrically isolated by the coupling arrangement (16; 116) from a signal evaluation circuit (18; 118) providing the state signal, **characterized in that** the coupling arrangement (16; 116) comprises an apparatus for producing a radio connection.

2. Rechargeable battery pack or battery pack (10; 100) according to Claim 1, **characterized in that** the coupling arrangement (16; 116) comprises a first coupling element for communicating with a second coupling element arranged outside of the rechargeable battery pack or the battery pack (10; 100).

3. Rechargeable battery pack or battery pack (10; 100) according to Claim 1, **characterized in that** the signal evaluation circuit (18; 118) provides a signal, on the basis of the items of cell information, via a temperature sensor (22) present in the rechargeable battery pack or the battery pack (10; 100) to the charging device or the consumer, by the signal evaluation circuit (18; 118) influencing an electrical variable of the temperature sensor (22).

4. Rechargeable battery pack or battery pack (10; 100) according to Claim 1, **characterized in that** the signal evaluation circuit (18; 118) provides a signal on the basis of the items of cell information via an optical or a radio interface or via an inductive or a capacitive coupling unit to the charging device or the consumer.

5. Rechargeable battery pack or battery pack (10; 100) according to Claim 1, **characterized in that** the signal evaluation circuit (18; 118) is designed to interrupt the flow of current into or out of the rechargeable battery pack or the battery pack via a switch provided in the rechargeable battery pack or the battery pack (10; 100) on the basis of the items of cell information.

6. Rechargeable battery pack or battery pack (100) according to any of Claims 1 to 5, **characterized in that** in each case a plurality of cells supplying a voltage are assigned (112) to one of the monitoring circuits (114).

## Revendications

1. Bloc d'accumulateurs ou de batteries (10 ; 100), comprenant plusieurs cellules (12 ; 112) individuelles délivrant une tension reliées les unes aux autres, un circuit de surveillance (14 ; 114) étant associé à chaque cellule (12 ; 112) pour surveiller une fonction de la cellule (12 ; 112) et pour délivrer, en fonction de celle-ci, une information de cellule, et chaque circuit de surveillance (14 ; 114) étant connecté à un arrangement de couplage (16 ; 116) qui, en fonction des informations de cellule, provoque la délivrance d'un signal d'état isolé galvaniquement de telle sorte que le circuit de surveillance (14 ; 114) est isolé galvaniquement par l'arrangement de couplage (16 ; 116) d'un circuit d'interprétation de signal (18 ; 118) qui délivre le signal d'état, **caractérisé en ce que** l'arrangement de couplage (16 ; 116) comprend un appareil pour établir une liaison radioélectrique.

2. Bloc d'accumulateurs ou de batteries (10 ; 100) selon la revendication 1, **caractérisé en ce que** l'arrangement de couplage (16 ; 116) comprend un premier élément de couplage destiné à communiquer avec un deuxième élément de couplage disposé à l'extérieur du bloc d'accumulateurs ou de batteries (10 ; 100).

3. Bloc d'accumulateurs ou de batteries (10 ; 100) selon la revendication 1, **caractérisé en ce que** le circuit d'interprétation de signal (18 ; 118) délivre au chargeur ou au consommateur un signal dépendant des informations de cellule par le biais d'une sonde de température (22) présente dans le bloc d'accumulateurs ou de batteries (10 ; 100), **en ce que** le circuit d'interprétation de signal (18 ; 118) influence une grandeur électrique de la sonde de température (22).

4. Bloc d'accumulateurs ou de batteries (10 ; 100) selon la revendication 1, **caractérisé en ce que** le circuit d'interprétation de signal (18 ; 118) délivre au chargeur ou au consommateur un signal dépendant des informations de cellule par le biais d'une interface optique ou radioélectrique ou par le biais d'une unité de couplage inductive ou capacitive.

5. Bloc d'accumulateurs ou de batteries (10 ; 100) selon la revendication 1, **caractérisé en ce que** le circuit d'interprétation de signal (18 ; 118) est configuré pour interrompre le flux de courant dans le bloc d'accumulateurs ou de batteries en fonction des informations de cellule par le biais d'un commutateur présent dans le bloc d'accumulateurs ou de batteries (10 ; 100).

6. Bloc d'accumulateurs ou de batteries (100) selon l'une des revendications 1 à 5, **caractérisé en ce que** plusieurs cellules délivrant une tension sont respectivement associées (112) à l'un des circuits de surveillance (114).
